(19) Europäisches Patentamt
European Patent Office
Office européen des brevets

(11) Publication number: 0 679 866 A2

(12) **EUROPEAN PATENT APPLICATION**

(21) Application number: **95106579.6**

(51) Int. Cl.⁶: **G01C 19/56**

(22) Date of filing: **02.05.95**

(30) Priority: **29.04.94 JP 114077/94**

(43) Date of publication of application:
**02.11.95 Bulletin 95/44**

(84) Designated Contracting States:
**DE FR GB IT SE**

(71) Applicant: **MURATA MANUFACTURING CO., LTD.**
**26-10, Tenjin 2-chome**
**Nagaokakyo-shi**
**Kyoto-fu 226 (JP)**

(72) Inventor: **Horikawa, Katsuhiro, Murata Manuf. Co., Ltd.**
**26-10, Tenjin 2-chome**
**Nagaokakyo-shi,**
**Kyoto-fu (JP)**
Inventor: **Ando, Akira, Murata Manuf. Co., Ltd.**
**26-10, Tenjin 2-chome**
**Nagaokakyo-shi,**
**Kyoto-fu (JP)**
Inventor: **Hayashi, Seigou, Murata Manuf. Co., Ltd.**
**26-10, Tenjin 2-chome**
**Nagaokakyo-shi,**
**Kyoto-fu (JP)**
Inventor: **Otsuki, Takehiko, Murata Manuf. Co., Ltd.**
**26-10, Tenjin 2-chome**
**Nagaokakyo-shi,**
**Kyoto-fu (JP)**
Inventor: **Hase, Kiyoshi, Murata Manuf. Co., Ltd.**
**26-10, Tenjin 2-chome**
**Nagaokakyo-shi,**
**Kyoto-fu (JP)**
Inventor: **Shiratsuyu, Kosuke, Murata Manuf. Co., Ltd.**
**26-10, Tenjin 2-chome**
**Nagaokakyo-shi,**
**Kyoto-fu (JP)**

(74) Representative: **Schoppe, Fritz, Dipl.-Ing.**
**Patentanwalt,**
**Georg-Kalb-Strasse 9**
**D-82049 Pullach (DE)**

(54) **Piezoelectric vibrating gyroscope.**

(57) A piezoelectric vibrating gyroscope 10 includes a vibrator 12, the vibrator 12 includes, for example, a regular triangular prism-shaped vibrating body 13. On central portions of three side surfaces of the vibrating body 13, piezoelectric elements 14a, 14b and 14c are formed, respectively. The piezoelectric elements 14a, 14b and 14c include piezoelectric layers 16a, 16b and 16c consisting of a piezoelectric material, respectively. A material which does not cause the phase transition from a piezoelectric phase (a ferroelectric phase) to another piezoelectric phase within the temperature range of the use of the piezoelectric vibrating gyroscope 10 is used as the piezoelectric material of the piezoelectric layers 16a-16c.

EP 0 679 866 A2

FIG.1

10
22
14b
22
12
13

## BACKGROUND OF THE INVENTION

### Field of the Invention

The present invention relates to a piezoelectric vibrating gyroscope, more particularly, to a piezoelectric vibrating gyroscope used a piezoelectric effect and applied to a navigation system which detects a position of a mobile by detecting its rotational angular velocity and guides it properly, a yaw rate sensor which detects an external vibration and damps it properly, or the like.

### Description of the Prior Art

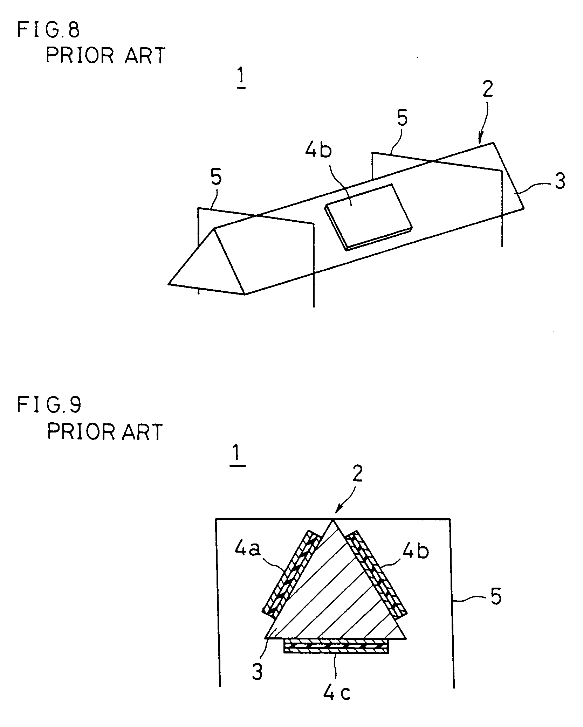

Fig. 8 is a perspective view showing an example of a conventional piezoelectric vibrating gyroscope using a piezoelectric material which is a background of the present invention, Fig. 9 is a sectional view thereof. The piezoelectric vibrating gyroscope 1 includes a vibrator 2. The vibrator 2 includes, for example, a regular triangular prism-shaped vibrating body 3, the vibrating body 3 is formed with a material which generates generally a mechanical vibration such as elinver. On three side surfaces of the vibrating body 3, three piezoelectric elements 4a, 4b and 4c are bonded by, for example, an adhesive, respectively. Each of the piezoelectric elements 4a, 4b and 4c includes each piezoelectric layer made of a piezoelectric material. Each electrode is formed on each of both main surfaces of the piezoelectric layers, each electrode on each one main surface of the piezoelectric layers is bonded to the vibrating body 3. Furthermore, supporting members 5, 5 are installed to the vicinity of nodal points of the vibrating body 3.

When the piezoelectric vibrating gyroscope 1 is used, an oscillation circuit source is connected, for example, between the piezoelectric elements 4a and 4b and the piezoelectric element 4c. By an output signal obtained from the oscillation circuit source, the vibrating body 3 bends and vibrates in a direction perpendicular to the side surface whereon the piezoelectric element 4c is formed. When the piezoelectric vibrating gyroscope 1 rotates about its axis, an output voltage difference corresponding to a rotational angular velocity is generated between the piezoelectric elements 4a and 4b. By measuring the output voltage difference generated between the piezoelectric elements 4a and 4b, the rotational angular velocity applied to the piezoelectric vibrating gyroscope 1 can be detected.

However, in the conventional piezoelectric vibrating gyroscope, within the temperature range of the use of the piezoelectric vibrating gyroscope, by changing the atmospheric temperature, a voltage excepting a voltage corresponding to a rotational angular velocity is generated, it causes an large error on a measurement in the piezoelectric vibrating gyroscope. In the conventional piezoelectric vibrating gyroscope, since an output voltage and a response speed are changed by changing a material characteristic of the piezoelectric material to form a part of the vibrator, when the change of the material characteristic of the piezoelectric material by changing the atmospheric temperature becomes large, there is a problem that the characteristic such as a measurement accuracy and the response speed is large changed by changing the atmospheric temperature.

## SUMMARY OF THE INVENTION

Therefore, it is primary object of the present invention to provide a piezoelectric vibrating gyroscope wherein an error on a measurement is small and the change of the characteristic such as the measurement accuracy and the response speed is small even if the atmospheric temperature changes.

The present invention is directed to a piezoelectric vibrating gyroscope using a piezoelectric effect and including a vibrator used a piezoelectric material, characterized in that the piezoelectric material is a material which does not cause the phase transition within the temperature range of the use of the piezoelectric vibrating gyroscope.

The present invention is directed to a piezoelectric vibrating gyroscope using a piezoelectric effect and including a vibrator consisting of a piezoelectric material, characterized in that the piezoelectric material is a material which does not cause the phase transition within the temperature range of the use of the piezoelectric vibrating gyroscope.

Furthermore, the present invention is directed to a piezoelectric vibrating gyroscope using a piezoelectric effect and including a vibrator having a prism-shaped vibrating body which bends and vibrates and a piezoelectric element formed on the vibrating body, characterized in that a piezoelectric material of the piezoelectric element is a material which does not cause the phase transition within the temperature range of the use of the piezoelectric vibrating gyroscope.

Since the material which does not cause the phase transition within the temperature range of the use of the piezoelectric vibrating gyroscope is used as the piezoelectric material used in the vibrator of the piezoelectric vibrating gyroscope, the piezoelectric material used as the vibrator of the piezoelectric vibrating gyroscope, or the piezoelectric material of the piezoelectric element of the vibrator in the piezoelectric vibrating gyroscope, even if the atmospheric temperature changes, an error on a measurement in the piezoelectric vibrating gyroscope is small and the change of the characteristic such as the measurement accuracy and the response speed in the piezoelectric vibrating gyroscope is small.

According to the present invention, it can obtain a piezoelectric vibrating gyroscope wherein an error on a measurement is small and the change of the characteristic such as the measurement accuracy and the response speed is small even if the atmospheric temperature changes.

The above and other objects, features, aspects and advantages of the present invention will become more apparent from the following detailed description of the embodiments with reference to the accompanying drawings.

## BRIEF DESCRIPTION OF THE DRAWINGS

Fig. 1 is a perspective view showing an embodiment of the present invention.

Fig. 2 is a sectional view of a piezoelectric vibrating gyroscope shown in Fig. 1.

Fig. 3 is a block diagram showing a circuit for using the piezoelectric vibrating gyroscope shown in Fig. 1.

Fig. 4(A) is a graph showing the change of mechanical quality factor Qm in each piezoelectric element by changing the atmospheric temperature, Fig. 4(B) is a graph showing the change of resonance frequency in each piezoelectric element by changing the atmospheric temperature.

Fig. 5 is a graph showing the change of pyroelectric charge generated in each piezoelectric element by changing the atmospheric temperature.

Fig. 6 is a graph showing the change of output voltage difference at rotation in each piezoelectric vibrating gyroscope by changing the atmospheric temperature.

Fig. 7 is a graph showing the change of response speed in each piezoelectric vibrating gyroscope by changing the atmospheric temperature.

Fig. 8 is a perspective view showing an example of a conventional piezoelectric vibrating gyroscope using a piezoelectric material which is a background of the present invention.

Fig. 9 is a sectional view of the piezoelectric vibrating gyroscope shown in Fig. 8.

## DESCRIPTION OF THE PREFERRED EMBODIMENTS

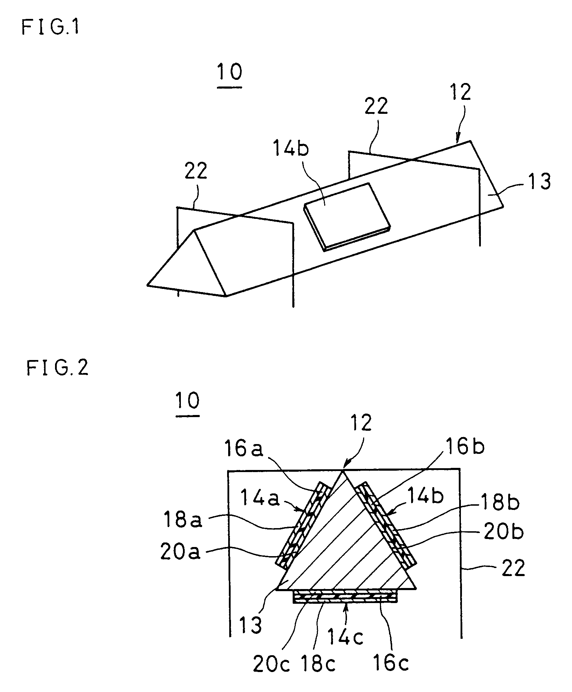

Fig. 1 is a perspective view showing an embodiment of the present invention, Fig. 2 is a sectional view thereof. The piezoelectric vibrating gyroscope 10 of the embodiment includes a vibrator 12, the vibrator 12 includes, for example, a regular triangular prism-shaped vibrating body 13. The vibrating body 13 is formed with a constant elastic metal material such as elinver or a material which generates generally a mechanical vibration such as glass, quartz, crystal and ceramics.

On central portions of three side surfaces of the vibrating body 13, piezoelectric elements 14a, 14b and 14c are formed, respectively. The piezoelectric element 14a includes a piezoelectric layer 16a consisting of a piezoelectric material, electrodes 18a and 20a are formed on both main surfaces of the piezoelectric layer 16a, respectively. Then, one electrode 20a is bonded to the side surface of the vibrating body 13. Similarly, the piezoelectric elements 14b and 14c include piezoelectric layers 16b and 16c consisting of a piezoelectric material, electrodes 18b, 20b, 18c and 20c are formed on both main surfaces of the piezoelectric layers 16b and 16c, respectively. Then, the electrodes 20b and 20c are bonded to the side surfaces of the vibrating body 13.

A piezoelectric material which does not cause the phase transition from a piezoelectric phase (a ferroelectric phase) to another piezoelectric phase within the temperature range of the use of the piezoelectric vibrating gyroscope 10 is used as a material of the piezoelectric elements 14a, 14b and 14c of the piezoelectric vibrating gyroscope 10 of the embodiment. Such a piezoelectric material can be obtained by, for example, changing contents of Zr and Ti in a piezoelectric ceramic material having Pb, Zr and Ti. Then, the material is molded and sintered, thereby the piezoelectric layers 16a, 16b and 16c are formed. Furthermore, the electrodes 18a, 20a, 18b, 20b, 18c and 20c are formed on both main surfaces of the piezoelectric layer 16a, 16b and 16c, thereby the piezoelectric element 14a, 14b and 14c are obtained.

The piezoelectric elements 14a, 14b and 14c are bonded to the vibrating body 13, thereby the vibrator 12 is formed. Furthermore, the supporting members 22, 22 are installed to the vicinity of nodal points of the vibrator 12 of the vibrating body 13, thereby the piezoelectric vibrating gyroscope 10 is manufactured.

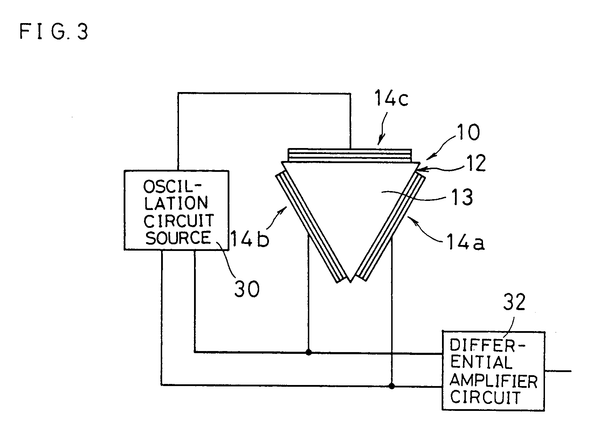

To study the characteristic of the piezoelectric vibrating gyroscope 10, as shown in Fig. 3, an oscillation circuit source 30 is connected between the piezoelectric elements 14a and 14b and the piezoelectric element 14c. Then, by a signal obtained from the oscillation circuit source 30, a vibration of the vibrating body 13 is excited. In this case, the vibrating body 13 bends and vibrates in a direction perpendicular to the side surface whereon the piezoelectric element 14c is bonded. In this state, outputs generated in the piezoelectric elements 14a and 14b are the same magnitude and polarity in voltage. Thus, when an output voltage difference between the piezoelectric elements 14a and 14b is measured by using a differential amplifier circuit 32, the difference becomes zero. Then, when the vibrating body 13 rotates about its axis, an output voltage difference is generated between the piezoelectric elements 14a and 14b by a Coriolis force. By measuring the output voltage difference, the rotational angular velocity applied to the piezoelectric vibrating gyroscope 10 can be detected.

At non-rotation in the piezoelectric vibrating gyroscope 10, the atmospheric temperature is changed within from -30°C to 85°C and the output voltage difference between the piezoelectric elements 14a and 14b is measured, the absolute value of the difference between the maximum value and the minimum value in the output voltage difference within the above-mentioned atmospheric temperature range presents a temperature drift. That is, when the output voltage difference between the piezoelectric elements 14a and 14b is most shifted from zero as an initial value at non-rotation, the output voltage difference presents the temperature drift of the piezoelectric vibrating gyroscope 10.

Furthermore, the piezoelectric vibrating gyroscope 10 rotates about the axis of the vibrating body 13 with a constant angular velocity, the atmospheric temperature is changed within from -30°C to 85°C and the output voltage difference between the piezoelectric elements 14a and 14b is measured, the change of the output voltage difference by changing the atmospheric temperature at rotation is studied.

Next, it will be compared with each other and explained that the characteristic wherein a material which does not cause the phase transition from a piezoelectric phase to another piezoelectric phase within the temperature range of the use of the piezoelectric vibrating gyroscope 10 is used as a material of the piezoelectric element 14a, 14b and 14c in the piezoelectric vibrating gyroscope 10 and the characteristic wherein a material which causes the phase transition within the temperature range of the use of the piezoelectric vibrating gyroscope 10 is used as a material of the piezoelectric element 14a, 14b and 14c in the piezoelectric vibrating gyroscope 10.

First, a piezoelectric ceramic material A and a piezoelectric ceramic material B are formed as a material of the piezoelectric elements 14a, 14b and 14c. The piezoelectric ceramic material A does not cause the phase transition from a piezoelectric phase to another piezoelectric phase within the above-mentioned atmospheric temperature range. The piezoelectric ceramic material B causes the phase transition within the above-mentioned atmospheric temperature range. The piezoelectric ceramic materials A and B are $PbZrO_3$-$PbTiO_3$ series piezoelectric ceramic materials. The contents of Zr of the piezoelectric ceramic materials A and B are different from each other, the contents of Ti of the piezoelectric ceramic materials A and B are different from each other, too. The contents of Zr and Ti of the piezoelectric ceramic materials A and B are shown in a table 1.

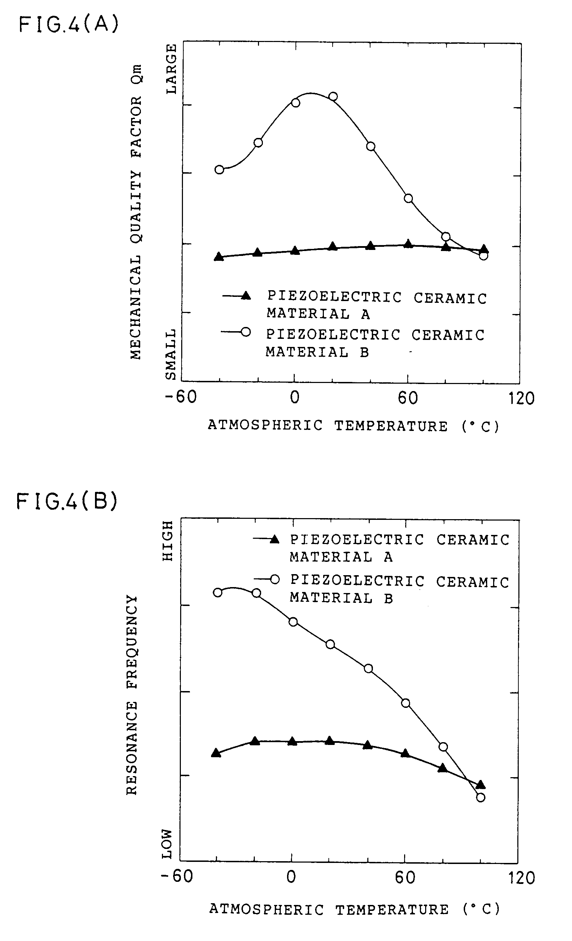

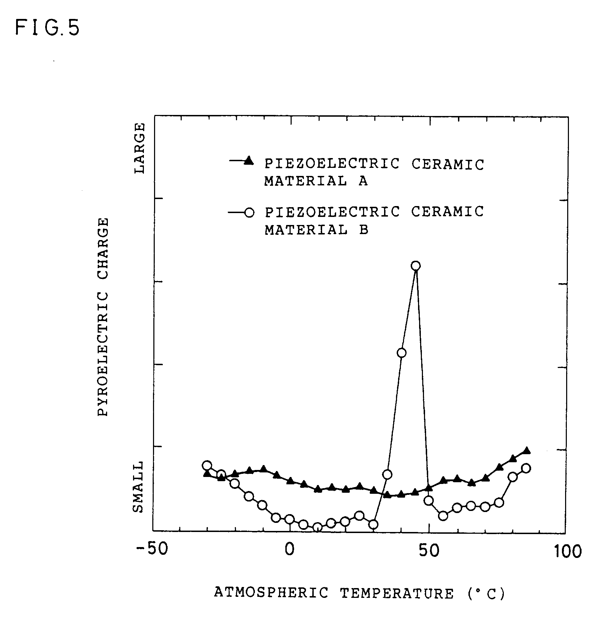

Then, a piezoelectric element is formed by using the piezoelectric ceramic material A, and further another piezoelectric element is formed by using the piezoelectric ceramic material B. The changes of material characteristics (mechanical quality factor Qm and resonance frequency) in the each piezoelectric element by changing the atmospheric temperature are shown in Fig. 4(A) and Fig. 4(B), and further the change of pyroelectric charge generated by the phase transition from a piezoelectric phase to another piezoelectric phase in the each piezoelectric element by changing the atmospheric temperature is shown in Fig. 5.

It is cleared by a graph shown in Fig. 5 that the piezoelectric element formed by using the piezoelectric ceramic material B shows a peek of pyroelectric charge at about 40° C within the above-mentioned atmospheric temperature range. That is, from the contents of Zr and Ti of the piezoelectric ceramic material B shown in the table 1, the piezoelectric ceramic material B is a composition in the vicinity of the phase boundary in composition so called MPB (morphotropic phase boundary), the piezoelectric ceramic material B shows to cause the phase transition from a piezoelectric phase to another piezoelectric phase by changing the atmospheric temperature. On the other hand, it is cleared by the graph shown in Fig. 5 that the piezoelectric ceramic element formed by using the piezoelectric ceramic material A does not show to generate any pyroelectric charge within the above-mentioned atmospheric temperature range and does not cause the phase transition from a piezoelectric phase to another piezoelectric phase within the atmospheric temperature range.

It is cleared by graphs shown in Fig. 4(A) and Fig. 4(B) that in the piezoelectric element formed by using the piezoelectric ceramic material A which does not cause the phase transition from a piezoelectric phase to another piezoelectric phase within the above-mentioned atmospheric temperature range, compared with the piezoelectric element formed by using the piezoelectric ceramic material B causes the phase transition within the above-mentioned atmospheric temperature range, the each change of the material characteristics by changing the atmospheric temperature is small, and a rate of the each change is hardly changed regardless of the atmospheric temperature.

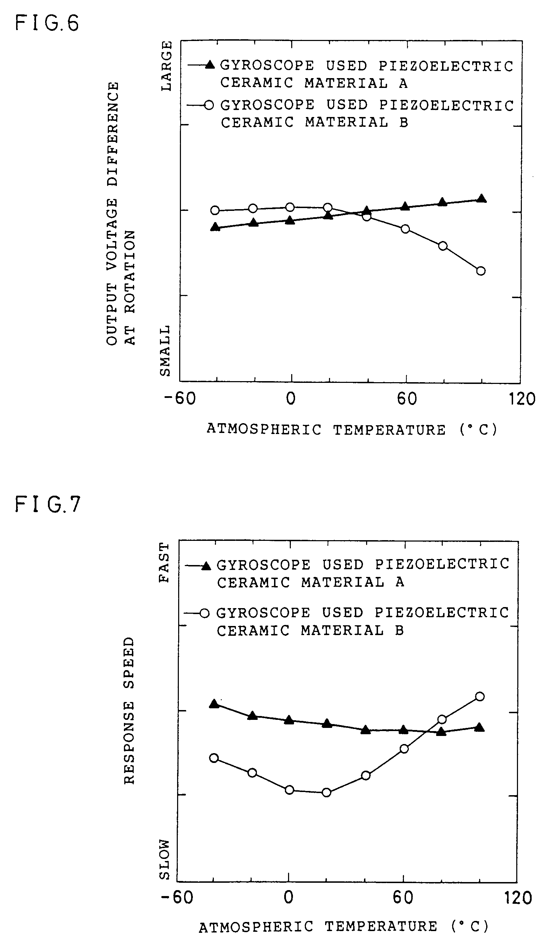

Then, the piezoelectric vibrating gyroscope 10 of the embodiment is manufactured by the piezoelectric element used the piezoelectric ceramic material A and so on, the piezoelectric vibrating gyroscope 10 of the comparison is manufactured by the piezoelectric element used the piezoelectric ceramic material B and so on. Then, in the each piezoelectric vibrating gyroscope 10 of the embodiment and the comparison, as shown in the above-mentioned, the temperature drift is detected and the change of the output voltage difference at rotation is studied, the each temperature drift is shown in a table 2, the change of the each output voltage difference at rotation is shown in Fig. 6.

Since the piezoelectric vibrating gyroscope 10 detects a rotational angular velocity applied thereto by an output voltage difference between the piezoelectric elements 14a and 14b, it is desirable that the output voltage difference at non-rotation is zero or about zero regardless of the atmospheric temperature. That is, it is desirable that the temperature drift is small. It is undesirable that the output voltage difference between the piezoelectric elements 14a and 14b at rotation is large changed by changing the atmospheric temperature, because it means that an accuracy on detecting the rotational angular velocity is large changed by the atmospheric temperature. That is, it is desirable that the change of the output voltage difference between the piezoelectric elements 14a and 14b by changing the atmospheric temperature is small.

It is cleared by results shown in the table 2 and Fig. 6 that in the piezoelectric vibrating gyroscope 10 of the embodiment used the piezoelectric ceramic material A, compared with the piezoelectric vibrating gyroscope 10 of the comparison used the piezoelectric ceramic material B, the temperature drift is small, the change of the output voltage difference between the piezoelectric elements 14a and 14b by changing the atmospheric temperature at rotation is small, the rate of the change is hardly changed. Because, by using the above-mentioned piezoelectric ceramic material A which does not cause the phase transition from a piezoelectric phase to another piezoelectric phase, the change of material characteristic of the piezoelectric elements 14a, 14b and 14c by changing the atmospheric temperature becomes small. Thus, by using the piezoelectric element used the piezoelectric material which does not cause the phase transition from a piezoelectric phase to another piezoelectric phase within the temperature range of the use of the piezoelectric vibrating gyroscope as the piezoelectric ceramic material A in the piezoelectric vibrating gyroscope, it can obtain a piezoelectric vibrating gyroscope wherein an error on a measurement is small and a change of a measurement accuracy is small even if the atmospheric temperature changes.

Next, in the each piezoelectric vibrating gyroscope 10 of the embodiment and the comparison, the change of response speed by changing the atmospheric temperature is studied, the result is shown in Fig. 7. It is cleared by the result shown in Fig. 7, in the piezoelectric vibrating gyroscope 10 of the embodiment used the piezoelectric ceramic material A, compared with the piezoelectric vibrating gyroscope 10 of the comparison used the piezoelectric ceramic material B, the change of response speed by changing the atmospheric temperature is small.

That is, a response characteristic of the piezoelectric vibrating gyroscope 10 shows the following formula (1) as a rising characteristic of a general vibrator.

$$1/t \fallingdotseq f/Qm \quad (1)$$

In the formula (1), 1/t represents a response speed, f represents a frequency of the vibrator 12, Qm represents a mechanical quality factor of the vibrator 12. Since the frequency of the vibrator 12 of the piezoelectric vibrating gyroscope 10 is regarded as about constant within the above-mentioned atmospheric temperature range, from the formula (1), the change of the response speed of the piezoelectric vibrating gyroscope 10 by changing the atmospheric temperature becomes fast as the change of the mechanical quality factor Qm by changing the atmospheric temperature becomes small. The change of the mechanical quality factor Qm of the vibrator 12 by changing the atmospheric temperature shows as tendency as the change of the mechanical quality factor Qm of the piezoelectric elements 14a, 14b and 14c by changing the atmospheric temperature. Thus, as shown in Fig. 4(A), the piezoelectric elements 14a, 14b and 14c wherein the change of the mechanical quality factor Qm by changing the atmospheric temperature is small are formed with the piezoelectric ceramic material A which does not cause the phase transition from a piezoelectric to another piezoelectric phase within the above-mentioned atmospheric temperature range, the piezoelectric elements 14a, 14b and 14c are used in the piezoelectric vibrating gyroscope 10, thereby the change of the response speed of the piezoelectric vibrating gyroscope 10 by changing the atmospheric temperature can be decreased.

As the above-mentioned, by forming a piezoelectric vibrating gyroscope with a piezoelectric element used a piezoelectric material which does not cause the phase transition from a piezoelectric phase to another piezoelectric phase within the atmospheric temperature range of the use of the piezoelectric vibrating gyroscope, it can obtain a piezoelectric vibrating gyroscope wherein an error on a measurement by changing the atmospheric temperature is small, the each change of the measurement accuracy and the response speed by changing the atmospheric temperature is small, and the change of the characteristic by changing the atmospheric temperature is small.

Meanwhile, though the vibrator wherein the piezoelectric elements are formed on the triangular prism-shaped vibrating body is used in the above-mentioned embodiment, the present invention can be applied to a piezoelectric vibrating gyroscope used a vibrator wherein piezoelectric elements are formed on a vibrating body of a prism-shape such as a rectangular prism-shape, a hexagonal prism-shape and a circular prism-shape, and a piezoelectric vibrating gyroscope used a vibrator wherein piezoelectric elements are formed on a vibrating body of another shape excepting the prism-shape, for example, a tuning fork shape such as an H-shape. Though each one electrode of the piezoelectric elements is bonded to the vibrating body in the above-mentioned embodiment, the each one electrode may be not formed and the piezoelectric layers may be formed directly on the vibrating body by an well-known thin film forming technology. In this case, by using a material which does not cause the phase transition from a piezoelectric phase to another piezoelectric phase within the temperature range of the use of the piezoelectric vibrating gyroscope as a piezoelectric material of the piezoelectric element, it can obtain the same effects as the above-mentioned embodiment.

Furthermore, though the vibrator wherein the piezoelectric elements are formed on the vibrating body in the above-mentioned embodiment, the present invention can be applied to a piezoelectric vibrating gyroscope using a vibrator wherein electrodes are formed on a vibrating body consisting of a piezoelectric material, too. A shape of a vibrator is not limited as the above-mentioned. In this case, by using a material which does not cause the phase transition from a piezoelectric phase to another piezoelectric phase within the atmospheric temperature range of the use of the piezoelectric vibrating gyroscope as a piezoelectric material of the vibrator, it can obtain the same effects as the above-mentioned embodiment.

It will be apparent from the foregoing that, while the present invention has been described in detail and illustrated, these are only particular illustration and example, and the present invention is not limited to these. The spirit and scope of the present invention is limited only by the appended claims.

TABLE 1

| | CONTENT OF Zr (mol %) | CONTENT OF Ti (mol %) |
|---|---|---|
| PIEZOELECTRIC CERAMIC MATERIAL A | 50 | 50 |
| PIEZOELECTRIC CERAMIC MATERIAL B | 46 | 54 |

The contents of Zr and Ti are the values converted so as to satisfy the relation shown in the following formula.

CONTENT OF Zr (mol %) + CONTENT OF Ti (mol %) = 100

TABLE 2

| | TEMPERATURE DRIFT (mV) |
|---|---|
| PIEZOELECTRIC VIBRATING GYROSCOPE USED PIEZOELECTRIC CERAMIC MATERIAL A | 80 |
| PIEZOELECTRIC VIBRATING GYROSCOPE USED PIEZOELECTRIC CERAMIC MATERIAL B | 120 |

## Claims

**1.** A piezoelectric vibrating gyroscope using a piezoelectric effect and including a vibrator used a piezoelectric material, characterized in that said piezoelectric material is a material which does not cause the phase transition within a temperature range of a use of the piezoelectric vibrating gyroscope.

**2.** A piezoelectric vibrating gyroscope according to claim 1, wherein said piezoelectric material is a material which does not cause the phase transition from a piezoelectric phase to another piezoelectric phase within the temperature range of the use of the piezoelectric vibrating gyroscope.

**3.** A piezoelectric vibrating gyroscope using a piezoelectric effect and including a vibrator consisting of a piezoelectric material, characterized in that said piezoelectric material is a material which does not cause the phase transition within a temperature range of a use of the piezoelectric vibrating gyroscope.

**4.** A piezoelectric vibrating gyroscope according to claim 3, wherein said piezoelectric material is a material which does not cause the phase transition from a piezoelectric phase to another piezoelectric phase within the temperature range of the use of the piezoelectric vibrating gyroscope.

5. A piezoelectric vibrating gyroscope using a piezoelectric effect and including a vibrator having a prism-shaped vibrating body which bends and vibrates and a piezoelectric element formed on said vibrating body, characterized in that a piezoelectric material of said piezoelectric element is a material which does not cause the phase transition within a temperature range of a use of the piezoelectric vibrating gyroscope.

6. A piezoelectric vibrating gyroscope according to claim 5, wherein said piezoelectric material is a material which does not cause the phase transition from a piezoelectric phase to another piezoelectric phase within the temperature range of the use of the piezoelectric vibrating gyroscope.

FIG.1

10
22
12
14b
22
13

FIG.2

10
12
16a
16b
14a
14b
18b
18a
20b
20a
22
13
14c
20c 18c
16c

FIG. 3

14c
10
12
13
14a
14b
OSCIL-
LATION
CIRCUIT
SOURCE
30
32
DIFFER-
ENTIAL
AMPLIFIER
CIRCUIT

FIG.4(A)

MECHANICAL QUALITY FACTOR Qm
LARGE
SMALL
-60
0
60
120
ATMOSPHERIC TEMPERATURE (°C)
PIEZOELECTRIC CERAMIC MATERIAL A
PIEZOELECTRIC CERAMIC MATERIAL B

FIG.4(B)

RESONANCE FREQUENCY
HIGH
LOW
-60
0
60
120
ATMOSPHERIC TEMPERATURE (°C)
PIEZOELECTRIC CERAMIC MATERIAL A
PIEZOELECTRIC CERAMIC MATERIAL B

FIG.5

PIEZOELECTRIC CERAMIC MATERIAL A
PIEZOELECTRIC CERAMIC MATERIAL B
LARGE
PYROELECTRIC CHARGE
SMALL
-50
0
50
100
ATMOSPHERIC TEMPERATURE (°C)

FIG.6

GYROSCOPE USED PIEZOELECTRIC CERAMIC MATERIAL A
GYROSCOPE USED PIEZOELECTRIC CERAMIC MATERIAL B
OUTPUT VOLTAGE DIFFERENCE AT ROTATION
LARGE
SMALL
-60
0
60
120
ATMOSPHERIC TEMPERATURE (°C)

FIG.7

GYROSCOPE USED PIEZOELECTRIC CERAMIC MATERIAL A
GYROSCOPE USED PIEZOELECTRIC CERAMIC MATERIAL B
RESPONSE SPEED
FAST
SLOW
-60
0
60
120
ATMOSPHERIC TEMPERATURE (°C)

FIG.8
PRIOR ART

1
2
5
4b
5
3

FIG.9
PRIOR ART

1
2
4a
4b
5
3
4c